Europäisches Patentamt

European Patent Office

Office européen des brevets

(19)

(11) Publication number : 0 214 802 B1

# (12) EUROPEAN PATENT SPECIFICATION

(45) Date of publication of patent specification :
05.06.91 Bulletin 91/23

(51) Int. Cl.⁵ : **H01L 29/36,** H01L 29/72, H01L 21/205

(21) Application number : 86306552.0

(22) Date of filing : 22.08.86

(54) **Semiconductor device having an abrupt junction and method of manufacturing same using epitaxy.**

(30) Priority : 26.08.85 JP 186902/85
29.08.85 JP 190777/85
29.08.85 JP 190786/85

(43) Date of publication of application :
18.03.87 Bulletin 87/12

(45) Publication of the grant of the patent :
05.06.91 Bulletin 91/23

(84) Designated Contracting States :
DE FR GB

(56) References cited :
EP-A- 0 166 498
DE-A- 2 805 008
GB-A- 1 304 246
US-A- 4 115 150
US-A- 4 380 774
PATENT ABSTRACTS OF JAPAN, vol. 8, no. 250 (E-279)[1687], 16th November 1984 & JP-A-59-125 680

(73) Proprietor : **MATSUSHITA ELECTRIC INDUSTRIAL CO., LTD.**
**1006, Oaza Kadoma**
**Kadoma-shi, Osaka-fu, 571 (JP)**

(72) Inventor : **Inada, Masanori**
**7-77 Ichihara Heguri-cho**
**Ikoma-gun Nara-ken, 636 (JP)**
Inventor : **Eda, Kazuo**
**2-614-5, Makinokitamachi**
**Hirakata-shi Osaka-fu, 573 (JP)**
Inventor : **Ota, Yorito**
**4-18-4, Seiryodai Tarumi-ku**
**Kobe-shi Hyogo-ken, 655 (JP)**

(74) Representative : **Crawford, Andrew Birkby et al**
**A.A. THORNTON & CO. Northumberland House 303-306 High Holborn**
**London WC1V 7LE (GB)**

## Description

The present invention relates to a method of manufacturing semiconductor devices such as bipolar transistors (hereinafter referred to as BTs) by using a multilayer structure material formed by epitaxial growth of semiconductor materials of different properties and which are useful as an ultrahigh frequency and ultrahigh-speed transistors. The invention concerns, in particular, the manufacturing of heterojunction bipolar transistors (hereinafter referred to as HBTs), semiconductor lasers and light emitting diodes.

In BTs, the high speed operation factors $f_t$ and $f_m$ are represented as :

$$f_t = \frac{1}{2\pi \left( \tau_e + \tau_b + \tau_c + \tau_{cc} \right)}$$

$$f_m = \sqrt{f_t}/\sqrt{8} \, \pi \, RbCbc$$

where

$\tau_e$ (emitter charging time) $= {}^r{}_e(Cbc + Ceb + Cpb)$.
$\tau_b$ (base transit time) $= Wb^2/nDb$,
$\tau_c$ (collector depletion layer transit time) $= Wc/2Vs$,
$\tau cc$ (collector depletion layer charging time) $= (Ree + Rc) \times (Cbc + Cpc)$,
Rb : base resistance,
Cbc : base-collector capacitance,
Ceb : base-emitter capacitance,
Cpb : base layer parasitic capacitance,
Cpc : collector layer parasitic capacitance,
Wb : base layer thickness,
Db : base layer diffusion coefficient,
Wc : collector depletion layer thickness,
Vs : collector transit speed,
Ree : emitter contact resistance, and
Rc : collector resistance.

As can be seen from the above formulae, it is important in BTs to reduce the junction capacitance (such as Cbc and Ceb), the base layer thickness Wb, the ohmic contact resistance and the base resistance Rb, in order to increase $f_t$ and $f_m$. Above all, it is important to reduce the base resistance Rb and the base-collector capacitance Cbc in order to increase $f_m$. In view of these requirements, attempts have been made to reduce the scale of transistors.

In HBTs in which a semiconductor material having a band gap larger than that of the base is used as the emitter, since leakage of holes from the base to the emitter is suppressed (in the case of npn type), the base can be doped to a greater extent, while the emitter and the collector can be doped to a lesser extent, contrary to the procedure for ordinary BTs. Since this doping regime can reduce the base resistance Rb, which is important for increasing the operation speed and frequency of the transistor, it has the advantage of increasing the factor $f_m$. Further, in conventional bipolar transistors, Ceb and Cbc are represented as the product of the factors Ceb (n, h), Cbc (n, h) of the junction capacitance as a function of the doping concentrations and the junction areas Aeb, Abc, respectively. Since the emitter and the collector are doped to a low concentration while the base is doped to a high concentration in a heterojunction bipolar transistor, Ceb (n, h) and Cbc (n, h) are dependent only on the doping concentrations of the emitter and of the collector, respectively, and Ceb and Cbc are represented as :

$$Ceb \, \alpha \, \sqrt{Ne} \cdot Aeb \qquad Cbc \, \alpha \, \sqrt{Nc} \cdot Abc.$$

Accordingly, since Ceb and Cbc are reduced in an HBT due to the differences between the heterostructure as compared with the conventional BT structure, $\tau_e$ and $\tau_{cc}$ are reduced with the advantage that $f_t$ is increased. Further, since Cbc is reduced, it provides an additional advantage of an increase in $f_m$, coupled with the decrease in Rb. To make the operation speed of the HBT higher, it is important to optimize the device structure as well as optimizing the hetero-structure itself. It is fundamentally possible to construct both a normal structure, in which the emitter is situated above the collector, and an inverted structure, in which the collector is situated above the emitter, in conventional BTs as well as HBTs (H. Kroemer: "Hetero-structure Bipolar Transistors and Integrated Circuits", Proc. IEEE, Vol. 70, p. 13, 1982). In the normal type, it is advantageous to reduce the size of the emitter in order to make Ceb smaller. In addition, if the collector can be made smaller by making the periphery of the collector semi-insulating, a significant increase in $f_t$ and $f_m$ is possible, since Cbc can be reduced (P.M. Asbeck, et al. "GaAs/(Ga, Al)As Heterojunction Bipolar Transistors with Buried Oxygen Implanted Isolation Layers", IEEE, EDL-5, p. 311 (1984)). Further, in the inverted structure, since the collector is situated above the emitter, it is advantageous to reduce the size of the collector in order to reduce Cbc. Also, since Ceb is reduced if the periphery of the emitter is made semi-insulating, $f_t$ and, accordinyly, $f_m$ can be increased. There have been attempts to achieve such an object by forming semiconductor materials of different properties into a multi-layer structure suitable for the manufacture of BTs by epitaxial growth and then making the periphery of the collector at a specific portion inside of the multilayer structure semi-insulating by ion implantation from above the structure (P.M. Asbeck, et al. "GaAs/(Ga, Al)As Heterojunction Bipolar Transistors with Buried Oxygen Implanted Isolation Layers", IEEE, EDL-5, p. 311 (1984).

However, the introduction of impurities into the specific portion inside of the multilayer structure from above it by means of ion implantation or diffusion is undesirable since it imparts detrimental effects to the transistor characteristics, and since the introduced impurities form a distribution as a function of depth into the structure, the impurities are also distributed above the specific portion which requires the introduction of impurities. Further, cristals of the semiconductor materials are inevitably damaged due to the large amount of impurities involved in the ion implantation or diffusion process.

A high-frequency transistor and method of making same wherein the parasitic capacitance between the base and the collector is reduced is disclosed in U.S. Patent 4,380,774. In the transistor the collector layer of GaAs is impregnated with boron ions to form an insulative region under the base contact structure thereby reducing the capacitance in this region and leaving only the region underlying the emitter structure as the active transistor region.

A double heterostructure light emitting semiconductor device is disclosed in European Patent 166,498. The device includes a p-GaAS substrate having a first electrode formed on one surface and a current confining layer on the other surface. A confined current conduction layer is formed in the current-confining layer and a light-emitting layer structure is formed on these layers. A capping layer of GaAs having a second electrode is formed on the light-emitting layer structure. A light exit window layer for exiting the emitted light is constructed by a thin film of the capping layer.

The object of the present invention is to provide a method of manufacturing of a semiconductor device having a multilayer structure in which additional impurities introduced into a specific portion of a desired layer, are present only in that layer and are substantially absent in other layers.

Another object of this invention is to provide a method of manufacturing of a semiconducteur device having a multilayer structure in which the other layers are not damaged when additional impurities are introduced into a desired layer by ion implantation or diffusion.

In this invention a method of manufacturing a semiconductor device, is provided including the use of a material suitable as a passivation film which is formed during the course of the production of the semiconductor device.

The present invention provides a method of manufacturing a semiconductor device using a multilayer structure of semiconductor materials in which impurities additionally introduced to a specific portion of the semiconductor materials are eliminated abruptly at a boundary between a semiconductor layer introduced with impurities and a layer thereabove and the properties of the semiconductors vary abruptly at said boundary,

characterized by comprising the steps of :

epitaxially forming on a substrate a multilayer structure of semiconductor materials and a passivation film thereover which serves to prevent the multilayer structure from being damaged by contact with an atmosphere during the subsequent step of introducing impurities and can be easily removed by heating at a temperature and in an atmosphere such that the epitaxially formed multilayer structure materials are not decomposed or vaporized ;

introducing impurities by ion implantation or diffusion into a specific portion of an uppermost layer of the multilayer structure ;

removing the passivation film in an epitaxy device ; and

epitaxially forming on said uppermost layer another semiconductor material layer.

Although the impurity-introduction step may be carried out either within or outside an epitaxy device, the effects of the passivation film can be significantly improved in the latter case. The introduction of impurities may be carried out, for example, by ion implantation or diffusion. The material employed as the passivation film comprises a material that can be easily removed at a temperature and in an atmosphere such that the materials forming the underlying layers are not decomposed or evaporated, and that can be formed by epitaxial growth. The passivation film serves to prevent the materials below it from being damaged by contact with the atmosphere during the impurity-introduction step.

In the case where the semiconductor device is a BT, the following process is applied. In the normal type of BT, there is at first formed, by epitaxial growth, at least one doped or undoped semiconductor material layer from which the collector is to be formed, on a substrate material and, then a passivation film layer for protecting the surface of the epitaxially grown layer grown on the substrate material. In the case of the inverted type of BT, there is formed by epitaxial growth, at least one doped or undoped semiconductor material layer from which the emitter is to be formed and then, on top of the emitter layer, a passivation film layer for protecting the surface of the epitaxially grown layer. Then, in the case where a doped layer is formed (i.e. where impurities are already present) the portion which is to form the collector or emitter region, as the case may be, is left unchanged while additional impurities are introduced to a portion surrounding the periphery thereof, by means of an impurity introduction process such as ion implantation or diffusion, thereby making this peripheral portion semi-insulating. In the case where an undoped (semi-insulating) layer has been formed, impurities are introduced into the region which is to form the collector or emitter region, as the case may be. Then, the passivation film is completely removed in an epitaxy device and, thereafter, further semiconductor material layers. required for forming the BT, are formed by epitaxial growth. In this way, a BT is formed with such a structure that :

(1) additional impurities are introduced into ther specific portion of epitaxially-formed layers in the multilayer structure ; (2) the introduced impurities are substantially abruptly confined to one side of the boundary between the portion having impurities introduced into it and the epitaxial layer formed immediately above it; (3) the properties of the semiconductor vary substantially abruptly at the aforementioned boundary ; and (4) the layers above the layer having impurities introduced into it do not suffer damage due to the introduction of the impurities.

The following process is also applicable. For a normal type BT, in the first epitaxial growth, at least one highly doped layer or undoped layer having carriers of a type identical with that of the collector and a passivation film layer thereover are formed by epitaxial growth and these comprise the semiconductor layer below the collector in the normal type. In the case of the inverted type BT, one highly doped layer or undoped semi-insulating layer having carriers of a type identical with that of the emitter, and a passivation film layer thereover, are formed by epitaxial growth, and these comprise the expitaxially formed semiconductor layer below the emitter in the inverted type. Then, in the case where a highly doped layer has been formed, while a portion smaller in size than that of the collector or emitter region, when formed, and located directly beneath the intended position of the collector or emitter region is left unchanged, a portion around the periphery of this portion is made semi-insulating by introducing impurities by ion implantation or diffusion. In the case where an undoped (i.e. semi-insulating) layer has been formed, a highly doped region is formed by introducing impurities into a portion smaller in size than that the collector or emitter region, when formed, and located directly beneath the intended position of the collector or emitter region. Then, after completely removing the passivation film layer, further semiconductor material layers, required to form the BT, are formed by epitaxial growth. In this case, impurities are introduced from above the multilayer structure thus formed so as to reduce the size of the collector or emitter region and to convert at least the periphery of the collector or the emitter into a region having carriers of a type identical with that of the base. Further, the ion implantation or like other process is carried out after applying a passivation film (composed of material capable of epitaxial growth which can be easily removed at a temperature and in an atmosphere such that the epitaxially-formed materials beneath it are not decomposed or evaporated). In particular, a method of epitaxially forming a protection film layer over the aforementioned passivation film layer, that can be selectively removed with ease outside the epitaxy device, is more effective, because the protection film layer prevents the underlying passivation film layer from being damaged through contact with air or other atmosphere and hence makes it easier to remove the passivation film layer and to form a multilayer-structure material having a regrown high quality boundary where regrowth begins.

In the manufacturing method according to this invention, a multilayer-structure material can be effectively formed, in which impurities are introduced into a specific portion of a layer inside the multilayer structure composed of epitaxially formed semiconductor materials of different properties, such that the introduced impurities are abruptly confined by the boundary between the portion of the layer having the impurities introduced into it and the layer immediately above it, and the properties of the semiconductor vary abruptly at the aforementioned boundary. Accordingly, it is possible to effectively form a minute collector region in a normal BT, in which the emitter is disposed above the collector region, and to form a minute emitter region in an inverted type BT, in which the collector is disposed above the emitter region, wherein the base-collector capacitance Cbc and the base-emitter capacitance Ceb can be greatly reduced. Further, since the distribution of the impurities is confined only to the portion requiring the introduction of the impurities, and since the layers above the layer having the impurities introduced into it do not suffer from damage due to the introduction of the impurities, the performance of the BT is not impaired.

Therefore, it is possible to manufacture a high performance BT according to the present invention.

A method of manufacturing a bipolar transistor according to this invention will now be described with reference to the accompanying drawings, in which :

Figure 1 illustrates a method of manufacturing a HBT according to a first embodiment of the present invention and a first example of the (normal type) HBT structure formed thereby ;

Figure 2 illustrates a method of manufacturing a HBT accordinG to a second embodiment of the present invention and a second example of the (normal type) HBT structure formed thereby ;

Figure 3 illustrates a method of manufacturing a HBT according to a third embodiment of the present invention and a third example of the (normal type) HBT structure formed thereby ;

Figure 4 illustrates a method of manufacturing a HBT according to a fourth embodiment of the present invention and a fourth example of the (normal type) HBT structure formed thereby ;

Figure 5 illustrates a method of manufacturing a HBT according to a fifth embodiment of the present invention and a fifth example of the (inverted type) HBT structure formed thereby ;

Figure 6 illustrates a method of manufacturing a HBT according to a sixth embodiment of the present invention and a sixth example of the (inverted type) HBT structure formed thereby ;

Figure 7 illustrates a method of manufacturing a HBT according to a seventh embodiment of the present invention and a seventh example of the (inverted type) HBT structure formed thereby ;

Figure 8 illustrates a method of manufacturing a HBT according to an eighth embodiment of the present invention and an eighth example of the (inverted type) HBT structure formed thereby.

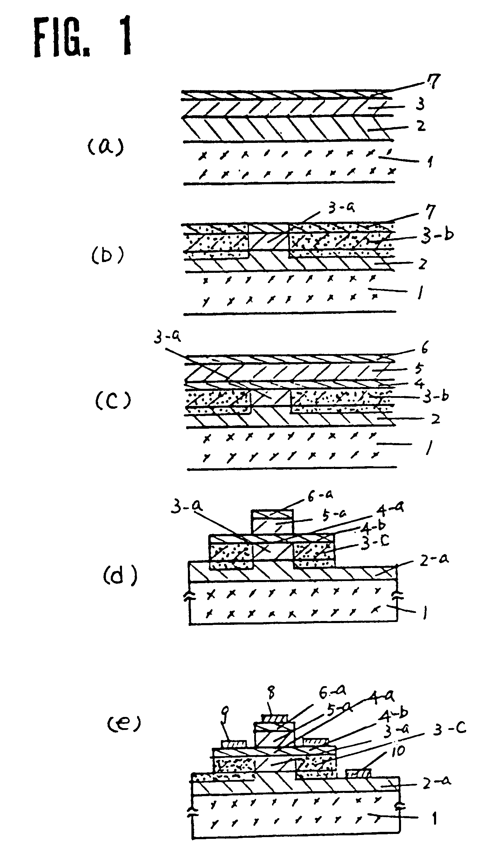

In Figures 1 to 8, the following features, indicated by reference signs are shown :

1, a substrate on which epitaxial growth is carried out ;

2, a highly doped semiconductor layer formed by epitaxial growth for facilitating the formation of the ohmic contact of a transistor's collector ;

2-a, the HBT-forming region of 2 ;

2-b, a portion of the layer 2 smaller in size than the collector region and situated just beneath the collector region in the layer 2 ;

2-c, a semi-insulating region formed around the periphery of the region 2-b in the layer 2 by uniformly introducing impurities ;

2-d, a yortion of 2-c disposed in the HBT-forming region ;

3, a semiconductor material layer doped for forming the collector ;

3-a, a collector region formed in the layer 3 ;

3-b, a semi-insulating region disposed in the layer 3 formed by the introduction of impurities ;

3-c, a portion of 3-b disposed in the HBT-forming portion ;

3-d, a region having carriers of a type identical with that of the base and disposed uniformly at the periphery of the collector region in the layer 3 ;

3-e, a portion of 3-d situated in the HBT-forming portion ;

4, a semiconductor layer doped for forming the base of the transistor ;

4-a, a base region for forming emitter-base and collector-base junctions ;

4-b, an external base region situated in the HBT-forming portion ;

5, a semiconductor layer doped for forming the emitter of the transistor ;

5-a, an emitter region disposed in the layer 5 ;

5-b, a region having carriers of a type identical with the base and disposed uniformly around the periphery of the emitter region 5-a in the layer 5, formed by introducing impurities ;

5-c, a semi-insulating region disposed uniformly around the periphery of the region 5-a in the layer 5, formed by introducing impurities ;

5-d, a portion of the region 5-c situated in the HBT-forming portion ;

5-e, a portion of 5-b situated in the HBT-forming portion ;

6, an epitaxially formed highly doped semiconductor layer for facilitating the formation of the ohmic contact of the transistor's emitter ;

6-a, a region for forming the ohmic contact of the emitter, formed in the portion of 6 ;

6-b, a region having carriers of a type identical with that of the base formed around the periphery of the region 6-a in the layer 6 by introducing impurities ;

6-c, a portion situated in the HBT-forming portion in the layer 6 ;

6-d, a portion of the layer 6 which is smaller in size than, and disposed just beneath, the emitter region ;

6-e, a semi-insulating region disposed uniformly around the periphery of the region 6-d in the layer 6, formed by introducing impurities ;

6-f, a portion of the region 6-e situated in the HBT-forming portion ;

7, an epitaxially formed passivation film layer ;

8, the emitter electrode of the transistor ;

9, the base electrode of the transistor ;

10, the collector electrode of the transistor ;

11, an epitaxially formed undoped semiconductor layer for forming the collector region of the transistor by introducing impurities ;

11-a, a collector region formed in the layer 11 by introducing impurities ;

11-b, a portion of the layer 11 situated in the HBT-forming portion ;

12, an undoped semi-insulating layer formed below the layer containing the collector region ;

12-a, a portion of the layer 12 which is highly doped by introducing the impurities within a region smaller in size than, and situated just beneath, the collector region ;

12-b, a portion of 12 situated in the HBT-forming region ;

13, an epitaxially formed undoped semiconductor layer for forming the emitter of a transistor by introducing impurities ;

13-a, an emitter region formed in the layer 13 by introducing impurities ;

13-b, a portion of the layer 13 situated in the HBT-forming region ;

14, an undoped semi-insulating layer disposed below the layer containing the emitter region ;

14-a, a portion of the layer 14 highly doped by introducing impurities within a region smaller in size than, and situated just beneath, the emitter region ;

14-b, a portion of the layer 14 situated in the HBT-forming portion.

## Example 1

Figure 1 illustrates a method of manufacturing a normal type HBT according to a first embodiment of the present invention and a first example of the HBT structure formed thereby. As shown in Figure 1(a), there are formed initially, in sequence, by epitaxial growth on a substrate 1, a highly doped semiconductor material layer 2 having carriers of a type identical with that of the collector of the HBT, a semiconductor material layer 3 from which the collector is to be formed, and a passivation film layer 7. Then, as shown in Figure 1(b), the peripheral portion 3-b around the small collector region 3-a is converted by way of ion implantation into a semi-insulating region 3-b. Then, after removing the passivation film layer 7 in an epitaxy device, there are formed, by epitaxial growth, as shown in Figure 1(c), a semiconductor material layer 4 from which a base 4-a is to be formed, a semiconductor material layer 5 from which an emitter is to be formed, and a highly doped semiconductor material layer 6 for facilitating the formation of the emitter ohmic contact. Then, as shown in Figure 1(d), a HBT device structure having an emitter region composed of regions 5-a and 6-a, an external base region 4-b and a region 2-a for forming a connection to the collector electrode are formed by photolithograyhy and etching of portions of the layers 6, 5, 4 and 3. Then, as shown in Figure 1(e), an emitter electrode 8, a base electrode 9 and a collector electrode 10 are formed to produce a HBT.

In the HBT structure according to this invention, impurities introduced for forming the peripheral portion 3-b around the collector region 3-a are restricted to the layer 3 from which the collector is to be formed and the lower portion thereof but are substantially absent in the base region 4-a, 4-b. Further, since the impurities introduced into the peripheral portion 3-b around the collector region 3-a do not pass through the base region 4-a, 4-b, the base region 4-a, 4-b is not damaged.

Example 2

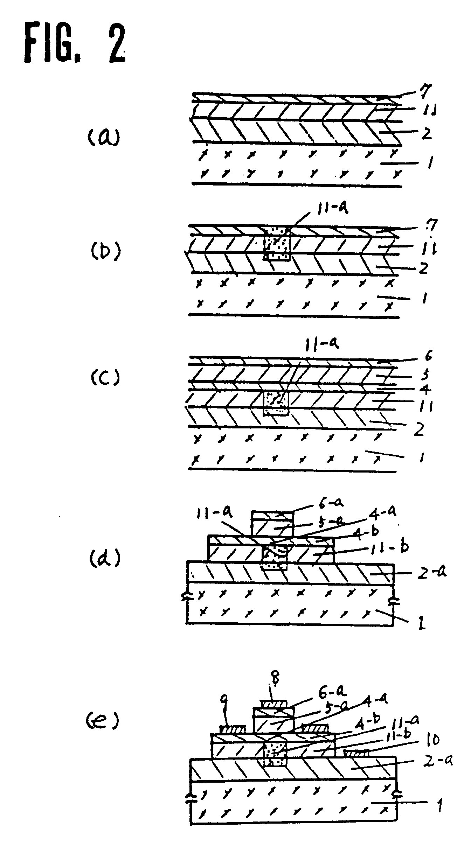

Figure 2 illustrates a method of manufacturing a normal type HBT according to a second embodiment of the present invention and a second example of the HBT structure formed thereby. As shown in Figure 2(a), there are formed initially, in sequence, by epitaxial growth on a substrate 1, a highly doped semiconductor material layer 2 for facilitating the formation of the ohmic contact of the HBT's collector, an undoped semiconductor material layer 11 from which the collector region is to be formed, and a passivation film layer 7. Then, as shown in Figure 2(b), a collector region 11-a is formed in a portion of the undoped layer 11 by means of ion implantation. Then, after removing the passivation film layer 7 in an epitaxy device, there are formed by epitaxial growth, as shown in Figure 2(c), a semiconductor material layer 4 from which a base region 4-a, 4-b is to be formed, a semiconductor material layer 5 from which an emitter region 5-a is to be formed, and a highly doped semiconductor material layer 6 for facilitating the formation of the emitter ohmic contact 6-a. Then, a HBT device structure shown in Figure 2(d) is formed by photolithography and etching of portions of the layers 6, 5, 4 and 11. Then, an emitter electrode 8, a base electrode 9 and a collector electrode 10 are formed to produce a HBT.

In this structure, the number of carriers in the collector region 11-a is increased by the introduction of additional impurities, and the peripheral portion 11-b around the collector region 11-a forms an undoped, semi-insulating region.

Example 3

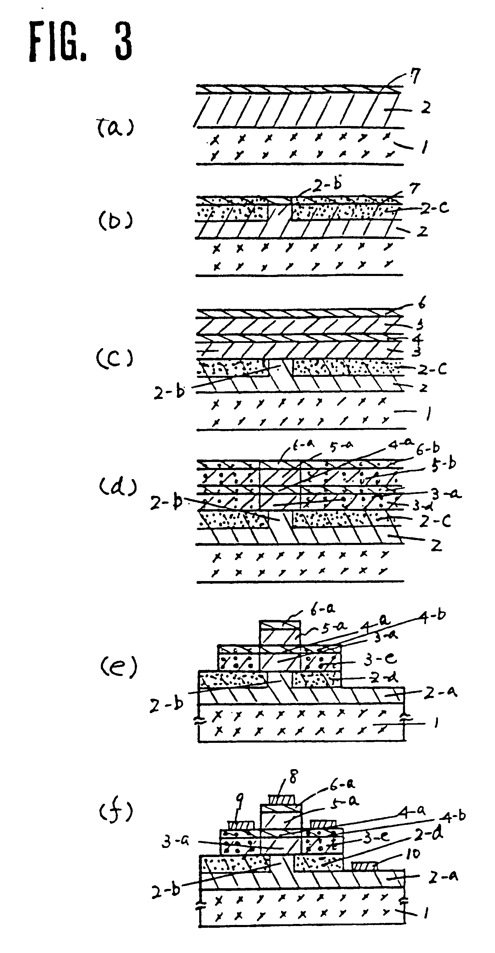

Figure 3 illustrates a method of manufacturing a normal type HBT according to a third embodiment of the present invention and a third example of the HBT structure formed thereby. As shown in Figure 3(a), there are formed initially in sequence, by epitaxial growth on a substrate 1, a highly doped semiconductor material layer 2 having charge carriers of a type identical with that of the collector of the HBT, and a passivation film layer 7. Then, as shown in Figure 3(b), a peripheral region 2-c around an inner region 2-b is concerted into a semi-insulating region 2-c by ion implantation while leaving the inner region 2-b smaller in size than the intended collector region and located so as to be just beneath the collector region 3-a when the latter is formed. Then, as shown in Figure 3(c), after removing the passivation film layer 7 in an epitaxy device, there are formed sequentially, by epitaxial growth, a semiconductor material layer 3 from which a collector region 3-a is to be formed, a semiconductor material region 4 from which a base region 4-a, 4-b is to be formed, a semiconductor material layer 5 from which an emitter region 5-a is to be formed, and a highly doped semiconductor material layer 6 for facilitating the formation of the ohmic contact 6-a of the HBT's emitter. Then, as shown in Figure 3(d), a peripheral portion 3-d around the collector region 3-a is converted into a region 3-d having carriers of a type identical with that of the base region 4-a, 4-b by means of ion implantation. Then a HBT device structure as shown in Figure 3(e) is formed by photolithography and etching of portions of layers 2, 3, 4, 5 and 6, in which a region 3-e, surrounding the collector region 3-a, is etched from the peripheral portion 3-d. Further, an emitter electrode 8, a base electrode 9 and a collector electrode 10 are formed to produce a HBT, as shown in Figure 3(f).

In this structure, the peripheral portion 3-e around the collector region 3-a constitutes a semiconductor region 3-e having the carriers of a type identical with that of the base region 4-a, 4-b. The layer immediately below the collector region 3-a comprises a highly doped region 2-b having carriers of a type identical with that of the collector region 3-a and is located just beneath the collector region 3-a. A semi-insulating region 2-d, having additional impurities introduced into it, is formed around the periphery of the highly doped region 2-b.

## Example 4

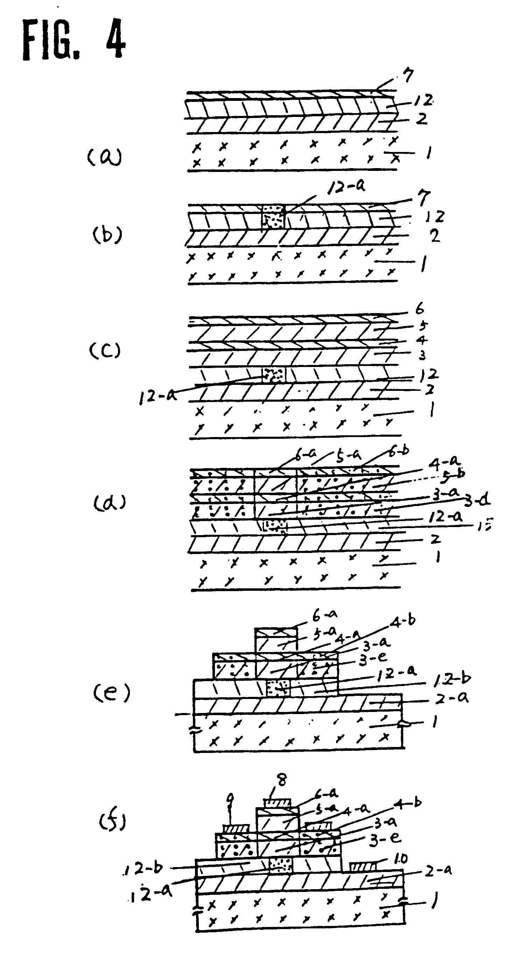

Figure 4 illustrates a method of manufacturing a normal type HBT according to a fourth embodiment of the present invention and a fourth example of a HBT structure formed thereby. As shown in Figure 4(a), there are formed initially, in sequence, by epitaxial growth on a substrate 1, a highly doped semiconductor material layer 2 having carriers of a type identical with that of the collector region of the HBT, an undoped semiconductor material layer 12 from which the collector is to be formed, and a passivation film layer 7. Then, as shown in Figure 4(b), a portion 12-a of the undoped layer 12 which is smaller in size than the collector region 3-a when formed, and situated just beneath the collector region 3-a, is converted into a highly doped region 12-a having carriers of a type identical with that of the collector region 3-a. Then, as shown in Figure 4(c), after removing the passivation film layer 7 in an epitaxy device, there are formed sequentially, by epitaxial growth, a semiconductor material layer 3 from which the collector region 3-a is to be formed, a semiconductor material layer 4 from which the base region 4-a, 4-b is to be formed, a semiconductor material layer 5 from which the emitter region 5-a is to be formed, and a semiconductor material layer 6 for facilitating the formation of the ohmic contact 6-a of the HBT's emitter. Then, as shown in Figure 4(d), the peripheral portion 3-d around the collector region 3-a is converted into a highly doped region 3-d having carriers of a type identical with that of the base region 4-a, 4-b. Then, a HBT device structure shown in Figure 4(e) is formed by photolithoyraphy and etching of portions of the layers 1,2,3,4,5 and 6, in which a region 3-e, surrounding the collector region 3-a, is etched from the peripheral portion 3-d. An emitter electrode 8, a base electrode 9 and a collector electrode 10 are formed to produce a HBT as shown in Figure 4(f).

In the structure shown in Figure 4(f), the peripheral portion 3-e around the collector region 3-a forms a semiconductor region 3-e having carriers of a type identical with that of the base region 4-a, 4-b. The layer 12 immediately below the collector region 3-a comprises a highly doped region 12-a, having carriers of a type identical with that of the collector, which is smaller in size than the collector region 3-a and situated just beneath the collector region 3-a, and an undoped semi-insulating region 12-b around the periphery of the highly doped region 12-a.

## Example 5

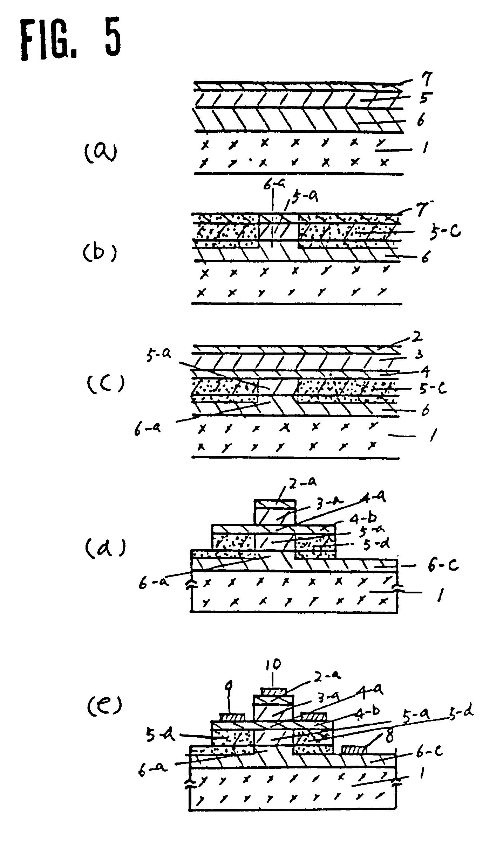

Figure 5 illustrates a method of manufacturing an inverted type HBT according to a fifth embodiment of the present invention and a fifth example of a HBT structure, formed thereby. As shown in Figure 5(a), there are formed initially, in sequence, by epitaxial growth on a substrate 1, a highly doped semiconductor material layer 6 having carriers of a type identical with that of the emitter of the HBT, a semiconductor material layer 5 from which an emitter region 5-a is to be formed, and a passivation film layer 7. Then, as shown in Figure 5(b), the peripheral portion 5-c around a minute emitter region 5-a is converted into a semi-insulating region 5-c by ion implantation while leaving the region 5-a unaffected. Then, after removing the passivation film layer 7 in an epitaxy device, there are formed sequentially, by epitaxial growth, as shown in Figure 5(c), a semiconductor material layer 4 from which a base region 4-a, 4-b is to be formed, a semiconductor material layer 3 from which a collector region 3-a is to be formed, and a semiconductor material layer 2 for facilitating the formation of the ohmic contact of the HBT's collector. Then, a HBT device structure shown in Figure 5(d) is formed by photolithography and etching of portions of the layers 2, 3, 4, 5 and 6. An emitter electrode 8, a base electrode 9 and a collector electrode 10 are formed as shown in Figure 5(d) to produce a HBT as illustrated in Figure 5(e).

In the structure shown in Figure 5(e), the impurities additionally introduced into the layer from which the emitter is formed are substantially absent from the base region 4-a, 4-b so that the base region is protected from damage.

## Example 6

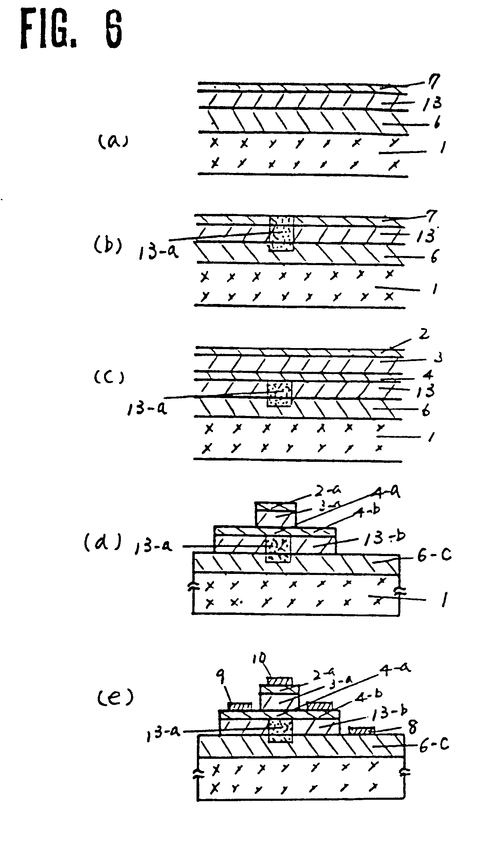

Figure 6 illustrates a method of manufacturing an inverted type HBT device according to a sixth embodiment of the present invention and a sixth example of a HBT structure formed thereby. As shown in Figure 6(a) there are formed initially, in sequence, by epitaxial growth on a substrate 1, a highly doped semiconductor material layer 6 having carriers of a type identical with that of the emitter of the HBT, an undoped semi-insulating material layer 13 and a passivation film layer 7. Then, as shown in Figure 6(b), impurities are introduced by ion implantation into a portion 13-a which will form an emitter region of the undoped layer 13. Then, after removing the passivation film layer 7 in an epitaxy device, there are formed sequentially, by epitaxial growth, as shown in Figure 6(c), a semiconductor material layer 4 from which a base region 4-a, 4-b is to be formed, a semiconductor material layer 3 from which a collector region 3-as is to be formed, and a highly doped semiconductor material layer 2 having carriers of a type identical with that of the collector region of the HBT. Then, a HBT device structure shown in Figure 6(d) is formed by photolithography and etching of portions of layers 2,3,4 and 13. An emitter electrode 8, a base electrode 9 and a collector electrode 10 are formed to produce a HBT as shown in Figure 6(e).

In the structure shown in Figure 6(e), carriers in the emitter region 13-a are formed by the introduction of additional impurities and the peripheral portion 13-b around the emitter region 13-a is an undoped semi-insulating region 13-b.

Example 7

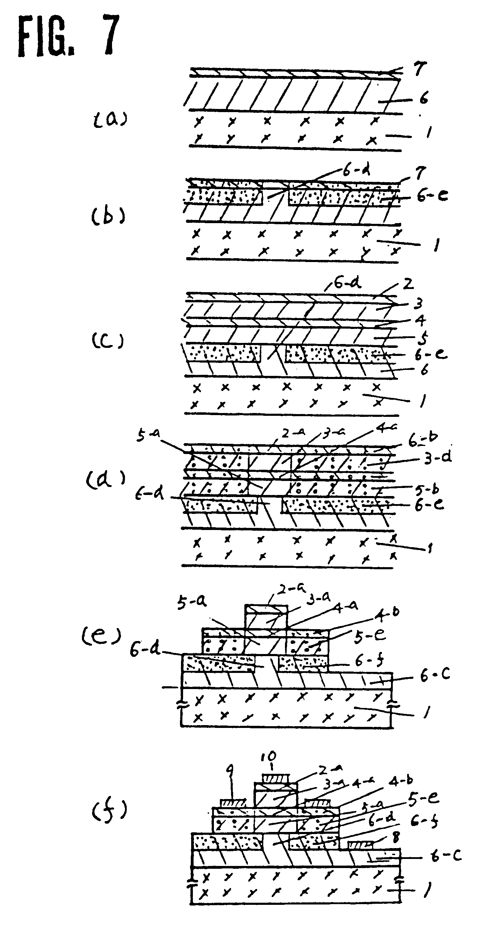

Figure 7 illustrates a method of manufacturing an inverted type HBT according to a seventh embodiment of the present invention and a seventh example of a HBT structure formed thereby. As shown in Figure 7(a), there are formed initially in sequence, by epitaxial growth on a substrate 1, a highly doped semiconductor material layer 6 having carriers of a type identical with that of an emitter region of the HBT and a passivation film layer 7. Then, as shown in Figure 7(b), the peripheral portion 6-e of the layer 6 is concerted into a semi-insulating region 6-e by means of ion implantation while leaving unaffected a portion 6-d, which is smaller in size than the emitter region 5-a, when formed, and located so as to be immediately below emitter region. Then, after removing the passivation film layer 7 in an epitaxy device, there are formed sequentially, by epitaxial growth as shown in Figure 7(c), a semiconductor material layer 5 from which the emitter region 5-a is to be formed, a semiconductor material layer 4 from which a base region 4-a, 4-b is to be formed, a semiconductor material layer 3 from which a collector region 3-a is to be formed, and a highly doped semiconductor material layer 2 having carriers of a type identical with that of the collector region 3-a. Then, as shown in Figure 7(d), the peripheral portion 5-b around the emitter region 5-a is converted into a region 5-b having carriers of a type identical with that of the base region 4-a, 4-b by ion implantation. Then HBT device structure shown in Figure 7(e) is formed by photolithography and etching of portions of layers 2, 3, 4, 5 and 6. An emitter electrode 8, a base electrode 9 and a collector electrode 10 are formed to produce a HBT as shown in Figure 7(f).

In the structure shown in Figure 7(f), the peripheral portion 5-b around the emitter region 5-a is converted into a semiconductor region 5-e having carriers of a type identical with that of the base during the photolighography and etching process. The layer immediately below the emitter region 5-a comprises a highly doped region 6-d, having carriers of a type identical with that of the emitter region 5-a, which is smaller in size than the emitter region 5-a and located immediately below the emitter region 5-a, and the peripheral portion 6-f, converted into a semi-insulating region by the introduction of additional impurities and formed from the peripheral portion 6-e during the photolithography and etching process.

Example 8

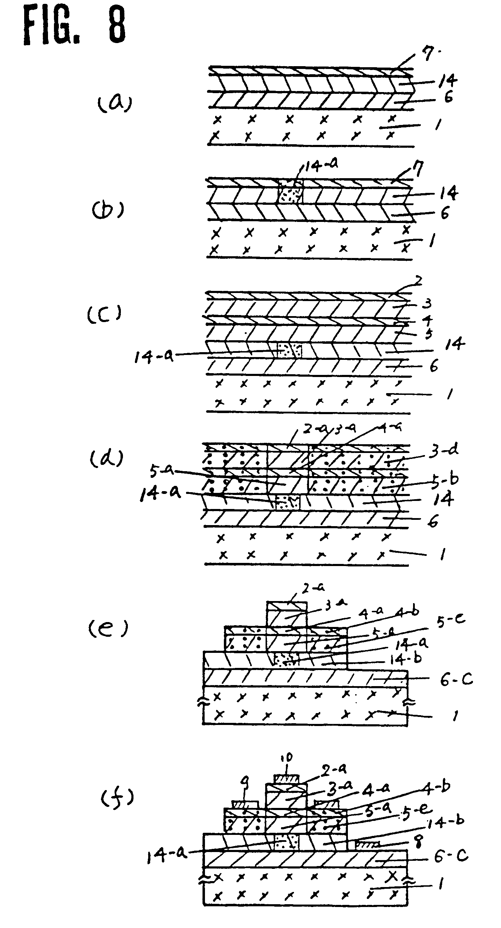

Figure 8 illustrates a method of manufacturing an inverted type HBT according to an eighth embodiment of the present invention and an eighth example of a HBT structure manufactured thereby. As shown in Figure 8(a), there are formed initially, in sequence, by epitaxial growth on a substrate 1, a highly doped semiconductor material layer 6 having carriers of a type identical with that of the emitter region of the HBT, an undoped semiconductor material layer 14 from which the emitter is to be formed and a passivation film layer 7. Then, as shown in Figure 8(b), a portion 14-a of the undoped layer situated so as to be immediately below the intended position of the emitter region 5-a is converted into a highly doped region 14-a having carriers of a type identical with that of the emitter region 5-a by ion implantation. Then, after removing the passivation film layer 7 in an epitaxy device, there are formed sequentially, by epitaxial growth, as shown in Figure 8(c), a semiconductor material layer 5 from which the emitter reqion 5-a is to be formed, a semiconductor material layer 4 from which a base region 4-a, 4-b is to be formed a semiconductor material layer 3 from which the collector region 3-a is to be formed, and a highly doped layer 2 having carriers of a type identical with that of the collector region 3-a. Then, as shown in Figure 8(d), the peripheral portion 5-b around the emitter region 5-a is converted into a region 5-b having carriers of a type identical with that of the base by ion implantation. Then, the HBT device structure shown in Figure 8(e) is formed by photolithography and etching of portions of layers 2,3,4,5 and 14. An emitter electrode 8, a base electrode 9 and a collector electrode 10 are formed to produce a HBT as shown in Figure 8(f).

In the structure shown in Figure 8(f), the peripheral portion 5-b around the emitter region 5-a is formed into a semiconductor region 5-e, having carriers of a type identical with that of the base, during the photolithography and etching process, and the layer immediately below the emitter region 5-a comprises a highly doped region 14-a having carriers of a type identical with that of the emitter region 5-a. The region 14-a is smaller in size than the emitter region 5-a and is situated immediately below it, an undoped semi-insulating region 14-b being formed around the periphery of the highly doped region 14-a.

The semiconductor materials employed in these examples are : highly doped n-type GaAs (n⁺-GaAs), as the material from which the ohmic contact of the HBT's emitter is formed ; n-type $Al_xGa_{l-x}As$), as the emitter material ; highly doped p-type GaAs(p⁺-GaAs), as the base material ; n-type GaAs(n-GaAs), as the collector material ; a highly doped n-type GaAs (n⁺-GaAs), as the material from which the ohmic contact for the HBT's collector is formed ; undoped GaAs (i-GaAs), as the undoped semi-insulating material from which the collector is formed; undoped $Al_xGa_{1-x}As(i-Al_xGa_{1-x}As)$, as the undoped semi-insulating material from which the emitter is formed ; and undoped GaAs(i-GaAs), as the undoped semi-insulating material from which the small highly doped region is formed. However, suitable alternative materials may be used to produce the bipolar transistor. For instance, it is also possible to use Si, Ge, GaAs, AlAs, InP, GaP, AlP or mixed crystals thereof, or a combination of those materials.

The materials used to form the passivation film may be any material that (1) can be formed epitaxially as a dense film, (2) can seal the epitaxially formed underlying materials to prevent their exposure to air or to other atmospheric components and (3) can be removed with ease without damaging the underlying epitaxially formed materials at such a temperature and in an atmosphere so as not to cause the decomposition or evaporation of the underlying materials. In the examples given, which use the GaAs-$Al_xGa_{1-x}As$ system, an epitaxially formed thin InAs film and an epitaxially formed passivation film comprising a dual layer structure of InAs and $Al_xGa_{1-x}As$ are used. Since InAs can be removed in the form of InAs at a temperature and in an As atmosphere which does not cause GaAs to decompose, it is suitable for use in the above system. Although it is desirable for easy removal in a short period of time to make the InAs film as thin as possible, a certain thickness is required to protect the surface. While on the other hand, although it is difficult, in the case of the dual layer passivation film in which $Al_xGa_{1-x}As$ is formed on InAs, to remove $Al_xGa_{1-x}As$ without damaging the underlying GaAs in an epitaxy device, $Al_xGa_{1-x}As$ with a relatively large x value can be simply removed by wet etching without damaging the InAs layer. If an $Al_xGa_{1-x}As$ layer with a relative large x value is used and the layer is made thicker, since InAs can be completely prevented from exposure to air or similar atmospheres, an InAs passivation film can be formed so thin that it may be removed in a short period of time just prior to the epitaxy process. It is extremely easy to selectively remove the $Al_xGa_{1-x}As$ layer just prior to placing the structure in the epitaxy device after carrying out the ion implantation or similar process, and the time during which the InAs is exposed to air can be reduced by placing the structure, directly after the removal of the $Al_xGa_{1-x}As$ layer, into the epitaxy device. Accordingly, the boundary can be sufficiently protected by a relatively thin InAs layer and since a thin layer may easily be removed just prior to epitaxy, it is highly advantageous to the process.

The materials used to form the passivation film layer include, bearing in mind the decomposition of vaporization temperature of the underlying epitaxially grown material : InAs, $In_xGa_{1-x}As$ or an epitaxially grown thin film comprising a plurality of layers, at least one of which comprises $Al_xGa_{1-x}As$ formed on InAs, or $In_xGa_{1-x}As$ (in the case where GaAs, AlAs, GaP, InP, a mixed crystal thereof or $In_xGa_{1-x}As$ is used as the underlying material) ; InAs, $In_xGa_{1-x}As$, GaAs, or an epitaxially grown thin film comprising a plurality of layers, at least one of which comprises $Al_xGa_{1-x}As$ formed on InAs, $In_xGa_{1-x}As$ or GaAs (in the case where $Al_xGa_{1-x}As$, Si, Ge or $Ge_xGa_{1-x}As$ is used as the underlying material) ; and InSb or $InSb_xAs_{1-x}$(in the case where GaAs, AlAs, InAs, Gap, InP, a mixed crystal thereof, or Ge, Si or $Ge_xSi_{1-x}$ is used as the underlying material).

Although the bipolar transistor produced according to the above examples is a HBT, the method according to the present invention may also be used to produce a BT having increased operation speed.

The use of an epitaxially grown thin film comprising a plurality of layers including a layer of $Al_xGa_{1-x}As$ formed on a layer of InAs, as in the above examples, finds applications outside the manufacture of BTs. This type of film may also be used in the production of those materials or devices which require the steps of applying an epitaxial process, intermediate subsequent processing, and then another epitaxial process. In the manufacture of a semiconductor laser, for example, it is possible to apply a passivation film and a process for forming pre-defined carrier region outside of an epitaxy device, and then to apply epitaxial growth again to thereby manufacture a semiconductor laser with a distinct region in which carriers are confined.

Further, althouyh in the above examples the passivation film is formed after forming the layer from which the collector is formed, or the layer immediately below it (in a normal type), and after forming the layer from which the emitter is formed or the layer immediately below it (in an inverted type), other processes are possible.

As has been described above, where, in the manufacture of semiconductor devices, impurities are introduced into specific portions of a multilayer structure of semiconductor materials of different properties, the present invention consists of a manufacturing method, which comprises epitaxially growing layers up to and including the layer into which impurities are to be introduced, epitaxially forming thereover a passivation film that can be easily removed by heating to a temperature and in an atmosphere such that the epitaxially formed materials formed under the film are not decomposed or vaporized, thereby protecting the epitaxially formed materials, then introducing impurities into desired portions by appropriate means such as ion implantation of the multilayer structure and, thereafter, removing the passivation film layer in an epitaxy device and then applying epitaxial growth again.

It is thus possible to manufacture a semiconductor device having a multilayer structure of semiconductor materials of different properties, in which impurities are additionally introduced into specific portions therein, in which the impurities are confined to one side of the boundary between the specified portion and the layer immediately above it, so that the properties of the semiconductor vary abruptly at the boundary between the layer into which the impurities have been introduced and the layer immediately above it, and the layers above the portion into which the impurities are introduced do not undergo damage resulting from the implantation process.

Accordingly, in a BT having the above-mentioned structure, Cbc and Rb can be reduced and, thus, the factor $f_m$ may be increased, since it is possible to manufacture a normal type BT (having an emitter disposed above the collector), in which a small collector has a semi-insulating region surrounding the periphery of the collector region, impurities are substantially absent in the base region above the semi-insulating region around the periphery of the collector, and the crystals of the base region are not damaged. Further, it is also possible to manufacture a BT in which a highly doped region having carriers of a type identical with that of the collector is formed in a portion of the layer situated immediately below the collector region, a region surrounding the periphery thereof containing carriers of a type identical with that of the base region, in which no impurities which would hinder the transistor operation are included in the peripheral portion around the collector region or the base region thereabove and crystals of the semiconductor materials are not damaged. This facilitates the manufacture of a BT with reduced Cbc and increased $f_m$.

In an inverted type BT (in which the collector is disposed above the emitter), since it is possible to manufacture a BT with a structure in which the collector and the emitter positions are transposed, it is possible to reduce Cbc by decreasing the size of the upper collector region, as well as to significantly increase $f_t$ and $f_m$ by reducing Ceb and Rb in the above-mentioned structure.

Further, in addition to a method of using a single layer of passivation film on the surface of an epitaxially grown layer, it is also possible according to the present invention, to employ a method of forming an epitaxially grown protection film layer over the above-mentioned passivation film layer, that can be selectively removed by etching from the above-mentioned passivation film layer, practicing ion implantation or a similar process, rapidly removing the protection film layer selectively from the above passivation film layer just before mounting the material in an epitaxy device, removing the passivation film layer in the epitaxy device and then applying the epitaxial growth again. According to such procedures, it is possible to manufacture a multilayer structure of semiconductor materials of different properties, wherein the properties at the boundary between the layer protected so far and the next epitaxial layer are much better.

Claims

1. A method of manufacturing a semiconductor device using a multilayer structure of semiconductor materials in which impurities additionally introduced to a specific portion of the semiconductor materials are eliminated abruptly at a boundary between a semiconductor layer introduced with impurities and a layer thereabove and the properties of the semiconductors vary abruptly at said boundary,
characterized by comprising the steps of :
epitaxially forming on a substrate (1) a multilayer structure of semiconductor materials (2, 3, 5, 6, 7-a, 11, 12, 13, 14) and a passivation film (7) thereover which serves to prevent the multilayer structure from being damaged by contact with an atmosphere during the subsequent step of introducing impurities and can be easily removed by heating at a temperature and in an atmosphere such that the epitaxially formed multilayer structure materials are not decomposed or vaporized; introducing impurities by ion implantation or diffusion into a specific portion (3-b, 2-c, 11-a, 12-a, 5-c, 6-e, 13-a, 14-a) of an uppermost layer of the multilayer structure ;
removing the passivation film in an epitaxy device ; and
epitaxially forming on said uppermost layer another semiconductor material layer (2, 3, 4, 5, 6).

2. A method according to claim 1, further including the steps of :
forming by epitaxial growth on the passivation film, a protection film layer which prevents the underlying passivation film from being damaged through contact with air or other atmosphere and can be selectively removed from the passivation film by etching ; and
selectively removing the protection film layer after introducing the impurities and just before mounting the sample in the epitaxy device.

3. A method according to claim 2, wherein the uppermost layer of the multilayer structure on which the passivation film is epitaxially formed comprises In$_x$Al$_{1-x}$As or at least one member selected from the group consisting of GaAs, AlAs, GaP and InP, the passivation film comprises In$_x$Ga$_{1-x}$As or As, and the protection film layer comprises Al$_x$Ga$_{1-x}$As.

4. A method according to claim 2, wherein the uppermost layer of the multilayer structure on which the passivation film is epitaxially formed comprises Al$_x$Ga$_{1-x}$As, Ge or Ge$_x$Si$_{1-x}$, the passivation film comprises InAs, In$_x$Al$_{1-x}$As or GaAs, and the protection film layer comprises Al$_x$Ga$_{1-x}$As.

5. A method according to claim 1 or 2, for manufacturing a bipolar transistor having a collector region, a base region and an emitter region which are formed in this order on a substrate characterized by comprising the steps of :

epitaxially forming at least a first semiconductor material layer (3) for forming the collector region and a passivation film (7) in this sequence ;

introducing impurities to the first semiconductor material layer (3-b) except for a specific part (3-a) thereof which becomes the collector region to make the first semiconductor material layer except for said specific part semi-insulating ;

eliminating said passivation film in an epitaxy device ;

epitaxially forming on the first semiconductor material layer at least a second semiconductor material layer (4) for forming the base region and a third semiconductor material layer (5) for forming the emitter region in this sequence ; and

patterning the second and third semiconductor material layers into specific patterns, respectively.

6. A method according to claim 5, wherein the emitter region is made of a semiconductor material having a band gap greater than that of a semiconductor material used for making the base region.

7. A method according to claim 1 or 2, for manufacturing a bipolar transistor having a collector region, a base region and an emitter region which are formed in this order on a substrate, characterised by comprising the steps of :

epitaxially forming a first semiconductor material layer (2) which is a highly doped semiconductor material layer for forming a collector ohmic contact region and a passivation film (7) in this sequence ;

introducing impurities to the first semiconductor material layer (2-c) except for a specific part (2-b) thereof which becomes the collector ohmic contact region to make the first semiconductor material layer except for said specific part semi-insulating ;

removing the passivation film in an eptaxy device;

epitaxially forming on the first semiconductor material layer at least a second semiconductor material lawyer (3) for forming the collector region, a third semiconductor material layer (4) for forming the base region and a fourth semiconductor material layer (5) for forming the emitter region in this sequence ;

introducing impurities to the second semiconductor material layer (3-d) except for a specific part (3-a) thereof which becomes the collector region to make the second semiconductor material layer except for said specific part thereof into a region having carriers of a type identical with that of the base region, said specific part of the second semiconductor material layer being larger in area than said specific part of the first semiconductor material layer ; and

patterning the third and fourth semiconductor material layers into specific patterns, respectively.

8. A method according to claim 7, wherein the emitter region is made of a semiconductor material having a band gap greater than that of a semiconductor material used for making the base region.

9. A method according to claim 1 or 2 for manufacturing a bipolar transistor having a collector region, a base region and an emitter region which are formed in this order on a substrate characterized by comprising the steps of :

epitaxially forming a first semiconductor material layer (2) which is a highly doped semiconductor material layer of a type identical with that of the collector region, a second semiconductor material layer (11) which is an undoped semiconductor material layer for forming the collector region and a passivation film (7) in this sequence ;

introducing impurities to the second semiconductor material layer at a specific part (11-a) thereof to make said specific part into the collector region ;

removing the passivation film in an epitaxy device ;

epitaxially forming on the second semiconductor material layer at least a third semiconductor material layer (4) for forming the base region and a fourth semiconductor material layer (5) for forming the emitter region in this sequence ; and

patterning the third and fourth semiconductor material layers into specific patterns, respectively.

10. A method according to claim 9, wherein the emitter region is made of a semiconductor material having a band gap greater than that of a semiconductor material used for making the base region.

11. A method according to claim 1 or 2, for manufacturing a bipolar transistor having a collector region, a base region and an emitter region which are formed in this order on a substrate, characterized by comprising the steps of :

epitaxially forming a first semiconductor material layer (2) which is a highly doped semiconductor material layer of a type identical with that of the collector region, a second semiconductor material layer (12) which is an undoped semiconductor material layer and a passivation film (7) in this sequence ;

introducing impurities to the second semiconductor material layer at a specific part (12-a) thereof to convert said specific part into a highly doped region of a type identical with the collector region;

removing the passivation film in an epitaxy device ;

epitaxially forming on the second semiconductor material layer at least a third semiconductor material layer (3) for forming the collector region, a fourth semiconductor material layer (4) for forming the base region and a fifth semiconductor material layer (5) for forming the emitter region in this sequence ;

introducing impurities to the third semiconductor material layer (3-d) except for a specific part (3-a) thereof which becomes the collector region to convert the third semiconductor material layer except for said specific quart thereof into a region having carriers of a type identical with that of the base region, said specific part of the third semiconductor material layer being larger in area than said specific quart of the second semiconductor material layer ; and

patterning the fourth and fifth semiconductor material layers into specific patterns, respectively.

12. A method according to claim 11, wherein the emitter region is made of a semiconductor material having a band gap greater than that of a semiconductor material used for making the base region.

13. A method according to claim 1 or 2 for manufacturing a bipolar transistor having an emitter region, a base region and a collector region which are formed in this order on a substrate, characterized by comprising the steps of :

epitaxially forming at least a first semiconductor material layer (5) for forming the emitter region and a passivation film (7) in this sequence ;

introducing impurities to the first semiconductor material layer (5-c) except for a specific part (5-a) thereof which becomes the emitter region to make the first semiconductor material layer except for said specific part semi-insulating ;

eliminating said passivation film in an epitaxy device ;

epitaxially forming on the first semiconductor aterial layer at least a second semiconductor material layer (4) for forming the base region and a third semiconductor material layer (3) for forming the collector region in this sequence ; and

patterning the second and third semiconductor material layers into specific patterns, respectively.

14. A method according to claim 13, wherein the emitter region is made of a semiconductor material having a band gap greater than that of a semiconductor material used for making the base region.

15. A method according to claim 1 or 2 for manufacturing a bipolar transistor having an emitter region, a base region and a collector region which are formed in this order on a substrate, characterized by comyrising the steps of :

epitaxially forming a first semiconductor material layer (6) which is a highly doped semiconductor material layer for forming an emitter ohmic contact region and a passivation film (7) in this sequence ;

introducing impurities to the first semiconductor material layer (6-e) except for a specific quart (6-d) thereof which becomes the emitter ohmic contact region to make the first semiconductor material layer except for said specific part semi-insulating ;

removing the passivation film in an epitaxy device ;

epitaxially forming on the first semiconductor material layer at least a second semiconductor material layer (5) for forming the emitter region, a third semiconductor material layer (4) for forming the base region and a fourth semiconductor material layer (3) for forming the collector region in this sequence ;

introducing impurities to the second semiconductor material layer (5-b) except for a specific part (5-a) thereof which becomes the emitter region to make the second semiconductor material layer except for said specific part thereof into a region having carriers of a type identical with that of the base region, said specific part of the second semiconductor material layer being larger in area than said specific part of the first semiconductor material layer ; and

patterning the third and fourth semiconductor material layers into specific patterns, respectively.

16. A method according to claim 15, wherein the emitter region is made of a semiconductor material having a band gap greater than that of a semiconductor material used for making the base region.

17. A method according to claim 1 or 2 for manufacturing a bipolar transistor having an emitter region, a base region and a collector region which are formed in this order on a substrate, characterized by comprising the steps of :

epitaxially forming a first semiconductor material layer (6) which is a highly doped semiconductor material layer of a type identical with that of the emitter region, a second semiconductor material layer (13) which is an undoped semiconductor material layer for forming the emitter region and a passivation film (7) in this sequence ;

introducing impurities to the second semiconductor material layer at a specific part (13-a) thereof to make said specific part into the emitter region; removing the passivation film in an epitaxy device ;

epitaxially forming on the second semiconductor material layer at least a third semiconductor material layer (4) for forming the base region and a fourth semiconductor material layer (3) for forming the collector region in this sequence ; and

patterning the third and fourth semiconductor material layers into specific patterns, respectively.

18. A method according to claim 17, wherein the emitter region is made of a semiconductor material having a band gap greater than that of a semiconductor material used for making the base region.

19. A method according to claim 1 or 2, for manufacturing a bipolar transistor having an emitter region, a base region and a collector region which are formed in this order on a substrate, said method comprising the steps of :

epitaxially forming a first semiconductor material layer (6) which is a highly doped semiconductor material layer of a type identical with that of the emitter region, a second semiconductor material layer (14) which is an undoped semiconductor material layer and a passivation film (7) in this sequence ;

introducing impurities to the second semiconductor material layer at a specific part (14-a) thereof to convert said specific part into a highly doped region of a type identical with the emitter region ;

removing the passivation film in an epitaxy device ;

epitaxially forming on the second semiconductor material layer at least a third semiconductor material layer (5) for forming the emitter region, a fourth semiconductor material layer (4) for forming the base region and a fifth semiconductor material layer (3) for forming the collector region in this sequence ;

introducing impurities to the third semiconductor material layer (5-b) except for a specific part (5-a) thereof which becomes the emitter region to convert the third semiconductor material layer except for said specific part thereof into a region having carriers of a type identical with that of the base region, said specific part of the third semiconductor material layer being larger in area than said specific part of the second semiconductor material layer ; and

patterning the fourth and fifth semiconductor material layers into specific patterns, respectively.

20. A method according to claim 19, wherein the emitter region is made of a semiconductor material a band gap greater than that of a semiconductor material used for making the base region.


**Ansprüche**

1. Verfahren zum Herstellen einer Halbleiter-Vorrichtung, die einen Mehrschichtenaufbau aus Halbleitern verwendet, bei dem Verunreinigungen, die zusätzlich in einen vorgeschriebenen Halbleiterabschnitt eingebracht werden, plötzlich an einer Grenzfläche zwischen einer mit eingebrachten Verunreinigungen versehenen Halbleiterschicht und einer darüberliegenden Schicht ausgeschaltet werden und sich die Halbleitereigenschaften plötzlich an dieser Grenzfläche ändern, gekennzeichnet durch die folgenden Schritte :

auf einer Unterlage (1) epitaxial einen Mehrschichtenaufbau aus Halbleitern (2, 3, 5, 6, 7-a, 11, 12, 13, 14) und darüber einen Passivitätsfilm (7) auszubilden, durch den eine Schädigung des Mehrschichtenaufbaus bei einer Berührung mit einer Atmosphäre während des nachfolgenden Schrittes, bei dem Verunreinigungen eingebracht werden, verhindert werden soll, und der durch Erwärmen bis auf eine solche Temperatur in einer Atmosphäre leicht entfernt werden kann, daß die Materialien des epitaxial ausgebildeten Mehrschichtenaufbaus weder zersetzt noch verdampft werden,

Verunreinigungen durch eine Ionenimplantation oder -diffusion in einen vorgeschriebenen Abschnitt (3-b, 2-c, 11-a, 12-a, 5-c, 6-e, 13-a, 14-a) einer obersten Schicht des Mehrschichtenaufbaus einzubringen,

den passivitätsfilm in einer der Epitaxie dienenden Vorrichtung zu entfernen und

eine Schicht (2, 3, 4, 5, 6) aus einem anderen Halbleiter auf der obersten Schicht epitaxial auszubilden.

2. Verfahren gemäß Anspruch 1 mit den weiteren Schritten :

auf dem Passivitätsfilm durch epitaxiales Wachstum eine Schicht eines Schutzfilmes auszubilden, die eine Schädigung des darunter liegenden Passivitätsfilmes durch eine Berührung mit Luft oder einer anderen Atmosphäre verhindert und durch Ätzen wahlweise von dem Passivitätsfilm entfernt werden kann, und

die Schicht des Schutzfilmes nach dem Einbringen der Verunreinigungen und gerade vor der Montage der Probe in der der Epitaxie dienenden Vorrichtung wahlweise zu entfernen.

3. Verfahren gemäß Anspruch 2, bei dem die oberste Schicht des Mehrschichtenaufbaues, auf der der Passivitätsfilm epitaxial ausgebildet wird, $In_xAl_{l-x}As$ oder mindestens den Bestandteil GaAs, AlAs, GaP oder InP, der Passivitätsfilm $In_xGa_{l-x}As$ oder As und die Schicht des Schutzfilmes $Al_xGa_{l-x}As$ enthält.

4. Verfahren gemäß Anspruch 2, bei dem die oberste Schicht des Mehrschichtenaufbaues, auf der der Passivitätsfilm epitaxial ausgebildet wird, $Al_xGa_{l-x}As$, Ge oder $Ge_xSi_{l-x}$, der Passivitätsfilm InAs, $In_xAl_{l-x}As$ oder GaAs und die Schicht des Schutzfilmes $Al_xGa_{l-x}As$ enthält.

5. Verfahren gemäß Anspruch 1 oder 2 zum Herstellen eines bipolaren Tranistors mit einem Kollektorbereich, einem Basisbereich und einem Emitterbereich, die in dieser Reihenfolge auf einer Unterlage ausgebildet werden, gekennzeichnet durch die folgenden Schritte :

zumindest eine erste Halbleiterschicht (3) zur Bildung des Kollektorbereiches und einen Passivitätsfilm (7) in dieser Reihenfolge epitaxial auszubilden,

Verunreinigungen in die erste Halbleiterschicht (3-b) mit Ausnahme in ihren einen vorgeschriebenen Teil (3-a) einzubringen, der der Kollektorbereich wird, um die erste Halbleiterschicht mit Ausnahme des vorgeschriebenen Teiles halbisolierend herzustellen,

den Passivitätsfilm in einer der Epitaxie dienenden Vorrichtung auszuschalten,

auf der ersten Halbleiterschicht zumindest eine zweite Halbleiterschicht (4) zur Bildung des Basisbereiches und eine dritte Halbleiterschicht (5) zur Bildung des Emitterbereiches in dieser Reihenfolge epitaxial auszubilden und

die zweite bzw. dritte Halbleiterschicht in je einem vorgeschriebenen Muster vorzusehen.

6. Verfahren gemäß Anspruch 5, bei dem der Emitterbereich aus einem Halbleiter mit einer Bandlücke hergestellt wird, die größer als die eines Halbleiters zur Bildung des Basisbereiches ist.

7. Verfahren gemäß Anspruch 1 oder 2 zum Herstellen eines bipolaren Transistors mit einem Kollektorbereich, einem Basisbereich und einem Emitterbereich, die in dieser Reihenfolge auf einer Unterlage ausgebildet werden, gekennzeichnet durch die folgenden Schritte :

eine erste stark dotierte Halbleiterschicht (2) zur Bildung eines ohmschen Kontaktes am Kollektorbereich und einen Passivitätsfilm (7) in dieser Reihenfolge epitaxial auszubilden,

Verunreinigungen in die erste Halbleiterschicht (2-c) mit Ausnahme in ihren einen vorgeschriebenen Teil (2-b) einzubringen, der der ohmsche Kontakt am Kollektorbereich wird, um die erste Halbleiterschicht mit Ausnahme des vorgeschriebenen Teiles halbisolierend zu machen,

den Passivitätsfilm in einer der Epitaxie dienender Vorrichtung zu entfernen,

auf der ersten Halbleiterschicht mindestens eine zweite Halbleiterschicht (3) zur Bildung des Kollektorbereiches, eine dritte Halbleiterschicht (4) zur Bildung des Basisbereiches und eine vierte Halbleiterschicht (5) zur Bildung des Emitterbereiches in dieser Reihenfolge epitaxial auszubilden,

Verunreinigungen in die zweite Halbleiterschicht (3-d) mit Ausnahme in ihren einen vorgeschriebenen Teil (3-a), der der Kollektorbereich wird, einzubringen, um die zweite Halbleiterschicht mit Ausnahme ihres vorgeschriebenen Teiles zu einem Bereich mit Trägern einer Art zu machen, die mit der des Basisbereiches identisch ist, wobei der vorgeschriebene Teil der zweiten Halbleiterschicht großflächiger als der vorgeschriebene Teil der ersten Halbleiterschicht ist, und

die dritte bzw. vierte Halbleiterschicht in je einem vorgeschriebenen Muster vorzusehen.

8. Verfahren gemäß Anspruch 7, bei dem der Emitterbereich aus einem Halbleiter hergestellt wird, dessen Bandlücke größer als die eines zur Herstellung des Basisbereiches verwendeten Halbleiters ist.

9. Verfahren gemäß Anspruch 1 oder 2 zum Herstellen eines bipolarer Transistors mit einem Kollektorbereich, einem Basisbereich und einem Emitterbereich, die in dieser Reihenfolge auf einer Unterlage ausgebildet werden, gekennzeichnet durch die folgenden Schritte :

eine erste stark dotierte Halbleiterschicht (2) von einer Art, die mit der des Kollektorbereiches identisch ist, eine zweite nicht dotierte Halbleiterschicht (11) zur Bildung des Kollektorbereiches und einen Passivitätsfilm (7) in dieser Reihenfolge epitaxial auszubilden,

Verunreinigungen in die zweite Halbleiterschicht an ihrem einen vorgeschriebenen Teil (11-a) einzubringen, um diesen Teil in den Kollektorbereich zu überführen,

den Passivitätsfilm in einer der Epitaxie dienenden Vorrichtung zu entfernen,

auf der zweiten Halbleiterschicht zumindest eine dritte Halbleiterschicht (4) zur Bildung des Basisbereiches und eine vierte Halbleiterschicht (5) zur Bildung des Emitterbereiches in dieser Reihenfolge epitaxial auszubilden und

die dritte bzw. vierte Halbleiterschicht in je einem vorgeschriebenen Muster vorzusehen.

10. Verfahren gemäß Anspruch 9, bei dem der Emitterbereich aus einem Halbleiter hergestellt wird, dessen Bandlücke größer als die eines zur Herstellung des Basisbereiches verwendeten Halbleiters ist.

11. Verfahren gemäß Anspruch 1 oder 2 zum Herstellen eines bipolaren Transistors mit einem Kollektorbereich, einem Basisbereich und einem Emitterbereich, die in dieser Reihenfolge auf einer Unterlage ausgebildet werden, gekennzeichnet durch die folgenden Schritte :

eine erste stark dotierte Halbleiterschicht (2) von einer Art, die mit der des Kollektorbereiches identisch ist, eine zweite nicht dotierte Halbleiterschicht (12) und einen Passivitätsfilm (7) in dieser Reihenfolge epitaxial auszubilden,

Verunreinigungen an einem vorgeschriebenen Teil (12-a) der zweiten Halbleiterschicht einzubringen, um diesen vorgeschriebenen Teil zu einem stark dotierten Bereich von einer Art umzuwandeln, die mit dem Kollektorbereich identisch ist,

den Passivitätsfilm in einer der Epitaxie dienenden Vorrichtung zu entfernen,

auf der zweiten Halbleiterschicht zumindest eine dritte Halbleiterschicht (3) zur Bildung des Kollektorbereiches, eine vierte Halbleiterschicht (4) zur Bildung des Basisbereiches und eine fünfte Halbleiterschicht (5) zur Bildung des Emitterbereiches in dieser Reihenfolge epitaxial auszubilden, Verunreinigungen in die dritte Halbleiterschicht (3-d) mit Ausnahme in ihren einen vorgeschriebenen Teil (3-a), der der Kollektorbereich wird, einzubringen, um die dritte Halbleiterschicht mit Ausnahme ihres vorgeschriebenen Teiles in einen Bereich mit Trägern von einer Art umzuwandeln, die mit der des Basisbereiches identisch ist, wobei der vorgeschriebene Teil der dritten Halbleiterschicht großflächiger als der vorgeschriebene Teil der zweiten Halbleiterschicht ist, und die vierte bzw. fünfte Halbleiterschicht in je einem vorgeschriebenen Muster vorzusehen.

12. Verfahren gemäß Anspruch 11, bei dem der Emitterbereich aus einem Halbleiter hergestellt wird, dessen Bandlücke größer als die eines zum Herstellen des Basisbereiches verwendeten Halbleiters ist.

13. Verfahren gemäß Anspruch 1 oder 2 zum Herstellen eines bipolaren Transistors mit einem Emitterbereich, einem Basisbereich und einem Kollektorbereich, die in dieser Reihenfolge auf einer Unterlage ausgebildet werden, gekennzeichnet durch die folgenden Schritte :

mindestens eine erste Halbleiterschicht (5) zur Bildung des Emitterbereiches und einen Passivitätsfilm (7) in dieser Reihenfolge epitaxial auszubilden,

Verunreinigungen in die erste Halbleiterschicht (5-c) mit Ausnahme in ihren einen vorgeschriebenen Teil (5-a), der der Emitterbereich wird, einzubringen, um die erste Halbleiterschicht mit Ausnahme ihres vorgeschriebenen Teiles halbisolierend zu machen,

den Passivitätsfilm in einer der Epitaxie dienenden Vorrichtung auszuschalten,

auf der ersten Halbleiterschicht mindestens eine zweite Halbleiterschicht (4) zur Bildung des Basisbereiches und eine dritte Halbleiterschicht (3) zur Bildung des Kollektorbereiches in dieser Reihenfolge epitaxial auszubilden und

die zweite bzw. dritte Halbleiterschicht in je einem vorgeschriebenen Muster vorzusehen.

14. Verfahren gemäß Anspruch 13, bei dem der Emitterbereich aus einem Halbleiter mit einer Bandlücke hergestellt wird, die größer als die eines zum Herstellen des Basisbereiches verwendeten Halbleiters ist.

15. Verfahren gemäß Anspruch 1 oder 2 zum Herstellen eines bipolaren Transistors mit einem Emitterbereich, einem Basisbereich und einem Kollektorbereich, die in dieser Reihenfolge auf einer Unterlage ausgebildet werden, gekennzeichnet durch die folgenden Schritte :

eine erste stark dotierte Halbleiterschicht (6) zur Bildung eines ohmschen Kontaktes am Emitterbereich und einen Passivitätsfilm (7) in dieser Reihenfolge epitaxial auszubilden,

Verunreinigungen in die erste Halbleiterschicht (6-e) mit Ausnahme in ihren einen vorgeschriebenen Teil (6-d), der der ohmsche Kontakt am Emitterbereich wird, einzubringen, um die erste Halbleiterschicht mit Ausnahme des vorgeschriebenen Teiles halbisolierend zu machen,

den Passivitätsfilm in einer der Epitaxie dienenden Vorrichtung zu entfernen,

auf der ersten Halbleiterschicht mindestens eine zweite Halbleiterschicht (5) zur Bildung des Emitterbereiches, eine dritte Halbleiterschicht (4) zur Bildung des Basisbereiches und eine vierte Halbleiterschicht (3) zur Bildung des Kollektorbereiches in dieser Reihenfolge epitaxial auszubilden,

Verunreinigungen in die zweite Halbleiterschicht (5-b) mit Ausnahme in ihren einen vorgeschriebenen Teil (5-a), der der Emitterbereich wird, einzubringen, um die zweite Halbleiterschicht mit Ausnahme ihres vorgeschriebenen Teiles zu einem Bereich mit Trägern von einer Art zu machen, die mit der des Basisbereiches identisch ist, wobei der vorgeschriebene Teil der zweiten halbleiterschicht großflächiger als der vorgeschriebene Teil der ersten halbleiterschicht ist, und die dritte bzw. vierte Halbleiterschicht in je einem vorgeschriebenen Muster vorzusehen.

16. Verfahren gemäß Anspruch 15, bei dem der Emitterbereich aus einem Halbleiter hergestellt wird, dessen Bandlücke größer als die eines zum Herstellen des Basisbereiches verwendeten Halbleiters ist.

17. Verfahren gemäß Anspruch 1 oder 2 zum Herstellen eines bipolaren Transistors mit einem Emitterbereich, einem Basisbereich und einem Kollektorbereich, die in dieser Reihenfolge auf einer Unterlage ausgebildet werden, gekennzeichnet durch die folgenden Schritte :

eine erste, stark dotierte Halbleiterschicht (6) von einer Art, die mit der des Emitterbereiches identisch ist, eine zweite nicht dotierte Halbleiterschicht (13) zur Bildung des Emitterbereiches und einen Passivitätsfilm (7) in dieser Reihenfolge epitaxial auszubilden,

Verunreinigungen in einen vorgeschriebenen Teil (13-a) der zweiten Helbleiterschicht einzubringen, um diesen vorgeschriebenen Teil zu dem Emitterbereich zu machen,

den Passivitätsfilm in einer der Epitaxie dienenden Vorrichtung zu entfernen,

auf der zweiten Halbleiterschicht mindestens eine dritte Halbleiterschicht (4) zur Bildung des Basisbereiches und eine vierte Halbleiterschicht (3) zur Bildung des Kollektorbereiches in dieser Reihenfolge epitaxial auszubilden und

die dritte bzw. vierte Halbleiterschicht in je einem vorgeschriebenen Muster vorzusehen.

18. Verfahren gemäß Anspruch 17, bei dem der Emitterbereich aus einem Halbleiter hergestellt wird, dessen Bandlücke größer als die eines zum Herstellen des Basisbereiches verwendeten Halbleiters ist.

19. Verfahren gemäß Anspruch 1 oder 2 zum Herstellen eines bipolaren Transistors mit einem Emitterbereich, einem Basisbereich und einem Kollektorbereich, die auf einer Unterlage in dieser Reihenfolge ausgebildet werden, mit den folgenden Schritten :

eine erste stark dotierte Halbleiterschicht (6) von einer Art, die mit der des Emitterbereiches identisch ist, eine zweite nicht dotierte Halbleiterschicht (14) und einen Passivitätsfilm (7) in dieser Reihenfolge epitaxial auszubilden,

Verunreinigungen in einen vorgeschriebenen Teil (14-a) der zweiten Halbleiterschicht einzubringen, um diesen vorgeschriebenen Teil zu einem stark dotierten Bereich von einer Art umzuwandeln, die mit dem Emitterbereich identisch ist,

den Passivitätsfilm in einer der Epitaxie dienenden Vorrichtung zu entfernen,

auf der zweiten Halbleiterschicht mindestens eine dritte Halbleiterschicht (5) zur Bildung des Emitterbereiches, eine vierte Halbleiterschicht (4) zur Bildung des Basisbereiches und eine fünfte Halbleiterschicht (3) zur Bildung des Kollektorbereiches in dieser Reihenfolge epitaxial auszubilden,

Verunreinigungen in die dritte Halbleiterschicht (5-b) mit Ausnahme in ihren einen vorgeschriebenen Teil (5-a) einzubringen, der der Emitterbereich wird, um die dritte Halbleiterschicht mit Ausnahme ihres vorgeschriebenen Teiles in einen Bereich mit Trägern von einer Art umzuwandeln, die mit der des Basisbereiches identisch ist, wobei der vorgeschriebene Teil der dritten Halbleiterschicht großflächiger als der vorgeschriebene Teil der zweiten Halbleiterschicht ist, und

die vierte bzw. fünfte Halbleiterschicht in je einem vorgeschriebenen Muster vorzusehen.

20. Verfahren gemäß Anspruch 19, bei dem der Emitterbereich aus einem Halbleiter hergestellt wird, dessen Bandlücke größer als die eines zum Herstellen des Basisbereiches verwendeten Halbleiters ist.

## Revendications

1. Procédé de fabrication d'un dispositif semiconducteur utilisant une structure à couches multiples de matières semi-conductrices, dans laquelle des impuretés introduites additionnellement dans une partie spécifique des matières semi-conductrices sont éliminées brusquement à une limite entre une couche semi-conductrice dans laquelle sont introduites des impuretés et une couche située au-dessous et les propriétés des semiconducteurs varient brusquement à ladite limite,

caractérisé en ce qu'il consiste essentiellement :

à former par croissance épitaxiale sur un substrat (1) une structure à couches multiples de matières semi-conductrices (2, 3, 5, 6, 7-a, 11, 12, 13, 14) et une pellicule de passivation (7) au-dessus qui a pour fonction d'empêcher que la structure à couches multiples soit endommagée par son contact avec une atmosphère pendant l'opération suivante d'introduction des impuretés et puisse facilement être éliminée par chauffage à une température et dans une atmosphère telles que les matières de la structure à couches multiples formée par croissance épitaxiale ne soient pas décomposées ou vaporisées ;

à introduire des impuretés par implantation ionique ou par diffusion dans une partie spécifique (3-b, 2-c, 11-a, 12-a, 5-c, 6-e, 13-a, 14-a) d'une couche supérieure de la structure à couches multiples ;

à éliminer la pellicule de passivation dans un dispositif à épitaxie ; et

à former par croissance épitaxiale sur ladite couche supérieure une autre couche de matière semi-conductrice (2, 3, 4, 5, 6).

2. Procédé selon la revendication 1, caractérisé en ce qu'il consiste en outre :

à former par croissance épitaxiale sur la pellicule de passivation, une pellicule de protection qui empêche que la pellicule de passivation sous-jacente soit endommagée par son contact avec de l'air ou autre atmosphère et qu'elle puisse être éliminée sélectivement de la pellicule de passivation par gravure ; et

à éliminer sélectivement la pellicule de protection après l'introduction des impuretés et juste avant le montage de l'échantillon dans le dispositif à épitaxie.

3. Procédé selon la revendication 2, dans lequel la couche supérieure de la structure à couches multiples sur laquelle la pellicule de passivation est formée par croissance épitaxiale consiste en $In_xAl_{1-x}As$ ou au moins un élément choisi dans le groupe comprenant GaAs, AlAs, GaP et InP, la pellicule de passivation consistant en $In_xGa_{1-x}As$ ou As et la pellicule de protection consistant en $Al_xGa_{1-x}As$.

4. Procédé selon la revendication 2, dans lequel la couche supérieure de la structure à couches multiples sur laquelle est formée par croissance épitaxiale la pellicule de passivation consiste en $Al_x Ga_{1-x}As$, Ge ou $Ge_xSi_{1-x}$, la pellicule de passivation consistant en InAs, $In_xAl_{1-x}As$ ou GaAs et la pellicule de protection consistant en $Al_xGa_{1-x}As$.

5. Procédé selon la revendication 1 ou 2, pour fabriquer un transistor bipolaire comprenant une région de collecteur, une région de base et une région d'émetteur qui sont formées dans cet ordre sur un substrat, caractérisé en ce qu'il consiste essentiellement

à former par croissance épitaxiale au moins une première couche de matière semi-conductrice (3) pour former la région de collecteur et une pellicule de passivation (7) dans cette séquence ;

à introduire des impuretés dans ladite première couche de matière semi-conductrice (3-b) à l'exception d'une partie spécifique (3-a) qui deviendra la région de collecteur afin de rendre semi-isolante la première couche de matière semi-conductrice à l'exception de ladite partie spécifique ;

à éliminer ladite pellicule de passivation dans un dispositif à épitaxie ; ·

à former par croissance épitaxiale sur la première couche de matière semi-conductrice au moins une seconde couche de matières semi-conductrices (4) dans le but de former la région de base et une troisième couche de matière semi-conductrice (5) dans le but de former la région d'émetteur, dans cette séquence ; et

à mettre en forme la seconde et la troisième couches de matières semi-conductrices dans des formes spécifiques respectivement.

6. Procédé selon la revendication 5, dans lequel la région d'émetteur est faite d'une matière semi-conductrice ayant un intervalle de bande supérieur à celui de la matière semi-conductrice utilisée pour réaliser la région de base.

7. Procédé selon la revendication 1 ou 2, pour fabriquer un transistor bipolaire comprenant une région de collecteur, une région de base et une région d'émetteur qui sont formées dans cet ordre sur un substrat, caractérisé en ce qu'il consiste essentiellement :

à former par croissance épitaxiale une première couche de matière semi-conductrice (2) qui est une couche de matière semi-conductrice fortement dopée destinée à former une région de contact ohmique de collecteur et une pellicule de passivation (7) dans cette séquence ;

à introduire des impuretés dans la première couche de matière semi-conductrice (2-c) à l'exception de sa partie spécifique (2-b) qui deviendra la région de contact ohmique de collecteur pour rendre semi-isolante la première couche de matière semi-conductrice à l'exception de ladite partie spécifique ;

à éliminer la pellicule de passivation dans un dispositif à épitaxie ;

à former par croissance épitaxiale sur la première couche de matière semi-conductrice au moins une seconde couche de matière de semi-conductrice (3) pour former la région de collecteur, une troisième couche de matière semi-conductrice (4) pour former la région de base et une quatrième couche de matière semi-conductrice (5) pour former la région d'émetteur, dans cette séquence ;

à introduire des impuretés dans la seconde couche de matière semi-conductrice (3-d) à l'exception de sa partie spécifique (3-a) qui deviendra la région de collecteur pour réaliser la seconde couche de matière semi-conductrice à l'exception de ladite partie spécifique dans une région contenant des porteurs d'un type identique à celui de la région de base, ladite partie spécifique de la seconde couche de matière semi-conductrice ayant une plus grande surface que ladite partie spécifique de la première couche de matière semi-conductrice ; et

à mettre en forme la troisième et la quatrième couches de matières semi-conductrices dans des configurations spécifiques respectivement.

8. Procédé selon la revendication 7, dans lequel la région d'émetteur est faite d'une matière semi-conductrice ayant un intervalle de bande supérieur à celui de la matière semi-conductrice utilisée pour réaliser la région de base.

9. Procédé selon la revendication 1 ou 2, pour fabriquer un transistor bipolaire comprenant une région de collecteur, une région de base et une région d'émetteur qui sont formées dans cet ordre sur un substrat, caractérisé en ce qu'il consiste essentiellement :

à former par croissance épitaxiale une première couche de matière semi-conductrice (2) qui est une couche de matière semi-conductrice fortement dopée d'un type identique à celui de la région de collecteur, une seconde couche de matière semi-conductrice (11) qui est une couche de matière semi-conductrice non dopée destinée à former la région de collecteur et une pellicule de passivation (7) dans cette séquence ;

à introduire des impuretés dans la seconde couche de matière semi-conductrice, à sa partie spécifique (11-a) pour réaliser ladite partie spécifique en la région de collecteur ;

à éliminer la pellicule de passivation dans un dispositif à épitaxie ;

à former par croissance épitaxiale sur la seconde couche de matière semi-conductrice au moins une troisième couche de matière semi-conductrice (4) pour former la région de base et une quatrième couche de matière semi-conductrice (5) pour former la région d'émetteur, dans cette séquence ; et

à mettre en forme respectivement dans des configurations spécifiques la troisième et la quatrième couches de matières semi-conductrices.

10. Procédé selon la revendication 9, dans lequel la région d'émetteur est faite d'une matière semi-conductrice ayant un intervalle de bande supérieur à celui de la matière semi-conductrice utilisée pour réaliser la région de base.

11. Procédé selon la revendication 1 ou 2, pour fabriquer un transistor bipolaire comprenant une région de collecteur, une région de base et une région d'émetteur qui sont formées dans cet ordre sur un substrat, caractérisé en ce qu'il consiste essentiellement :

à former par croissance épitaxiale une première couche de matière semi-conductrice (2) qui est une couche de matière semi-conductrice fortement dopée d'un type identique à celui de la région de collecteur, une seconde couche de matière semi-conductrice (12) qui est une couche de matière semi-conductrice non dopée et une pellicule de passivation (7), dans cette séquence;

à introduire des impuretés dans la seconde couche de matière semi-conductrice à sa partie spécifique (12-a) pour convertir ladite partie spécifique en une région fortement dopée d'un type identique à celui de la région de collecteur ;

à éliminer la pellicule de passivation dans un dispositif à épitaxie ;

à former par croissance épitaxiale sur la seconde couche de matière semi-conductrice au moins une troisième couche de matière semi-conductrice (3) destinée à former la région de collecteur, une quatrième couche de matière semi-conductrice (4) destinée à former la région de base et une cinquième couche de matière semi-conductrice (5) destinée à former la région d'émetteur, dans cette séquence ;

à introduire des impuretés dans la troisième couche de matière semi-conductrice (3-d) à l'exception près de sa partie spécifique (3-a) qui deviendra la région de collecteur pour convertir la troisième couche de matière semi-conductrice à l'exception de sadite partie spécifique en une région contenant des porteurs d'un type identique à celui de ladite région de base, ladite partie spécifique de la troisième couche de matière semi-conductrice ayant une plus grande surface que ladite partie spécifique de la seconde couche de matière semi-conductrice ; et

à mettre en forme la quatrième et la cinquième couches de matières semi-conductrices, respectivement dans des configurations spécifiques.

12. Procédé selon la revendication 11, dans lequel la région d'émetteur est faite d'une matière semi-conductrice ayant un intervalle de bande supérieur à celui de la matière semi-conductrice utilisée pour réaliser la région de base.

13. Procédé selon la revendication 1 ou 2 pour fabriquer un transistor bipolaire comprenant une région d'émetteur, une région de base et une région de collecteur qui sont formées dans cet ordre sur un substrat, caractérisé en ce qu'il consiste essentiellement :

à former par croissance épitaxiale au moins une première couche de matière semi-conductrice (5) destinée à former la région d'émetteur et une pellicule de passivation (7), dans cette séquence ;

à introduire des impuretés dans la première couche de matière semi-conductrice (5-c) à l'exception de sa partie spécifique (5-a) qui deviendra la région d'émetteur pour rendre semi-isolante la première couche de matière semi-conductrice à l'exception de ladite partie spécifique ;

à éliminer ladite pellicule de passivation dans un dispositif à épitaxie ;

à former par croissance épitaxiale sur la première couche de matière semi-conductrice, au moins une seconde couche de matière semi-conductrice (4) destinée à former la région de base et une troisième couche de matière semi-conductrice (3) destinée à former la région de collecteur, dans cette séquence ; et

à mettre en forme dans des configurations spécifiques respectivement la seconde et la troisième couches de matières semi-conductrices.

14. Procédé selon la revendication 13, dans lequel la région d'émetteur est faite d'une matière semi-conductrice ayant un intervalle de bande supérieur à celui de la matière semi-conductrice utilisée pour réaliser la région de base.

15. Procédé selon la revendication 1 ou 2, pour fabriquer un transistor bipolaire comprenant une région d'émetteur, une région de base et une région de collecteur qui sont formées dans cet ordre sur un substrat, caractérisé en ce qu'il consiste essentiellement :

à former par croissance épitaxiale une première couche de matière semi-conductrice (6) qui est une couche de matière semi-conductrice fortement dopée destinée à former une région de contact ohmique d'émetteur et une pellicule de passivation (7) dans cette séquence ;

à introduire des impuretés dans la première couche de matière semi-conductrice (6-e) à l'exception près de sa partie spécifique (6-d) qui deviendra la région de contact ohmique d'émetteur pour rendre semi-isolante la première couche de matière semi-conductrice à l'exception près de sadite partie spécifique ;

à éliminer la pellicule de passivation dans un dispositif à épitaxie ;

à former par croissance épitaxiale sur la première couche de matière semi-conductrice, au moins une seconde couche de matière semi-conductrice (5) destinée à former la région d'émetteur, une troisième couche de matière semi-conductrice (4) destinée à former la région de base et une quatrième couche de matière semi-conductrice (3) destinée à former la région de collecteur, dans cette séquence ;

à introduire des impuretés dans la seconde couche de matière semi-conductrice (5-b) à l'exception près de sa partie spécifique (5-a) qui deviendra la région d'émetteur pour réaliser la seconde couche de matière semi-conductrice. à l'exception près de sadite partie spécifique, en une région contenant des porteurs d'un type identique à celui de la région de base, ladite partie spécifique de la seconde couche de matière semi-conductrice ayant une plus grande surface que ladite partie spécifique de la première couche de matières semi-conductrices ; et

à mettre en forme la troisième et la quatrième couches de matières semi-conductrices dans des configurations spécifiques respectivement.

16. Procédé selon la revendication 15, dans lequel la région d'émetteur est faite d'une matière semi-conductrice ayant un intervalle de bande supérieur à celui de la matière semi-conductrice utilisée pour réaliser la région de base.

17. Procédé selon la revendication 1 ou 2, pour fabriquer un transistor bipolaire comprenant une région d'émetteur, une région de base et une région de collecteur qui sont formées dans cet ordre sur un substrat, caractérisé en ce qu'il consiste essentiellement :

à former par croissance épitaxiale une première couche de matière semi-conductrice (6) qui est une couche de matière semi-conductrice fortement dopée d'un type identique à celui de la région d'émetteur, une seconde couché de matière semi-conductrice (13) qui est une couche de matière semi-conductrice non dopée destinée à former la région d'émetteur et une pellicule de passivation (7) dans cette séquence ;

à introduire des impuretés dans la seconde couche de matière semi-conductrice dans sa partie spécifique (13-a) afin de réaliser ladite partie spécifique en une région d'émetteur ;

à éliminer la pellicule de passivation dans un dispositif à épitaxie ;

à former par croissance épitaxiale sur la seconde couche de matière semi-conductrice au moins une troisième couche de matière semi-conductrice (4) destinée à former la région de base et une quatrième couche de matière semi-conductrice (3) destinée à former la région de collecteur, dans cette séquence ; et

à mettre en forme dans des configurations spécifiques respectivement la troisième et la quatrième couches de matières semi-conductrices.

18. Procédé selon la revendication 17, dans lequel la région d'émetteur est faite d'une matière semi-conductrice ayant un intervalle de bande supérieur à celui de la matière semi-conductrice utilisée pour réaliser la région de base.

19. Procédé selon la revendication 1 ou 2, pour fabriquer un transistor bipolaire comprenant une région d'émetteur, une région de base et une région de collecteur qui sont formées dans cet ordre sur un substrat, ledit procédé consistant essentiellement :

à former par croissance épitaxiale une première couche de matière semi-conductrice (6) qui est une couche de matière semi-conductrice fortement dopée d'un type identique à celui de la région d'émetteur, une seconde couche de matière semi-conductrice (14) qui est une couche de matière semi-conductrice non dopée et une pellicule de passivation (7), dans cette séquence;

à introduire des impuretés dans la seconde couche de matière semi-conductrice dans sa partie spécifique (14-a) afin de convertir ladite partie spécifique en une région fortement dopée d'un type identique à celui de la région d'émetteur ;

à éliminer la pellicule de passivation dans un dispositif à épitaxie ;

à former, par croissance épitaxiale, sur la seconde couche de matière semi-conductrice au moins une troisième couche de matière semi-conductrice (5) destinée à former la région d'émetteur, une quatrième couche de matière semi-conductrice (4) destinée à former la région de base et une cinquième couche de matière semi-conductrice (3) destinée à former la région de collecteur, dans cette séquence ;

à introduire des impuretés dans la troisième couche de matière semi-conductrice (5-b) à l'exception près de sa partie spécifique (5-a) qui deviendra la région d'émetteur pour convertir ladite troisième couche de matière semi-conductrice à l'exception près de ladite partie spécifique en une région contenant des porteurs d'un type identique à celui de la région de base, ladite partie spécifique de la troisième couche de matière semi-conductrice ayant une plus grande surface que ladite partie spécifique de ladite seconde couche de matière semi-conductrice ; et

à mettre en forme dans des configurations spécifiques respectivement la quatrième et la cinquième couches de matières semi-conductrices.

20. Procédé selon la revendication 19, dans lequel la région d'émetteur est faite d'une matière semi-conductrice d'un intervalle de bande supérieur à celui de la matière semi-conductrice utilisée pour réaliser la région de base.

# FIG. 1

(a)

(b)

(c)

(d)

(e)

# FIG. 2

(a)

(b)

(c)

(d)

(e)

# FIG. 3

(a)

(b)

(c)

(d)

(e)

(f)

# FIG. 4

(a)

(b)

(c)

(d)

(e)

(f)

# FIG. 5

(a)

(b)

(c)

(d)

(e)

# FIG. 6

(a)

(b) 13-a

(C)

(d) 13-a

(e)

# FIG. 7

# FIG. 8

(a)

(b)

(c)

(d)

(e)

(f)